# EUROPÄISCHE PATENTSCHRIFT

(11) **EP 1 134 795 B1**
(45) Veröffentlichungstag und Bekanntmachung des Hinweises auf die Patenterteilung: **30.07.2003**
(21) Anmeldenummer: 01106383.1
(22) Anmeldetag: 19.03.2001
(51) Int. Cl.: H01L 21/28

(54) **Verfahren zur Einstellung der Schwellenspannung eines MOS - Transistors**
Method of adjusting the threshold voltage of a MOS transistor
Méthode pour ajuster la tension de seuil d'un transistor MOS

(30) Priorität: 17.03.2000 DE 10014916
(43) Veröffentlichungstag der Anmeldung: 19.09.2001
(73) Patentinhaber: Infineon Technologies AG, 81669 München (DE)
(72) Erfinder: Curello, Giuseppe, Dr., 01109 Dresden (DE); Wurzer, Helmut, Dr., 01109 Dresden (DE)
(74) Vertreter: Reinhard - Skuhra - Weise & Partner

(56) Entgegenhaltungen:
- EP-A- 0 707 346
- US-A- 5 426 069
- US-A- 5 633 177
- US-A- 5 888 867
- US-A- 6 114 206
- TSU-JAE KING ET AL: "A VARIABLE-WORK-FUNCTION POLYCRYSTALLINE-SI1-XGEX GATE MATERIAL FOR SUBMICROMETER CMOS TECHNOLOGIES" IEEE ELECTRON DEVICE LETTERS,US,IEEE INC. NEW YORK, Bd. 12, Nr. 10, 1. Oktober 1991 (1991-10-01), Seiten 533-535, XP000226014 ISSN: 0741-3106
- YU B ET AL: "GATE ENGINEERING FOR DEEP-SUBMICRON CMOS TRANSISTORS" IEEE TRANSACTIONS ON ELECTRON DEVICES,US,IEEE INC. NEW YORK, Bd. 45, Nr. 6, 1. Juni 1998 (1998-06-01), Seiten 1253-1261, XP000754177 ISSN: 0018-9383
- LI V Z -Q ET AL: "SINGLE GATE 0.15 MUM CMOS DEVICES FABRICATED USING RTCVD IN-SITU BORON DOPED SI1-XGEX GATES" WASHINGTON, DC, DEC. 7 - 10, 1997,NEW YORK, NY: IEEE,US, 7. Dezember 1997 (1997-12-07), Seiten 833-836, XP000855922 ISBN: 0-7803-4101-5

## Beschreibung

Die vorliegende Erfindung betrifft ein Verfahren zur Einstellung der Schwellenspannung eines MOS-Transistors gemäß dem Oberbegriff des Anspruches 1, wie aus der U.S.-A-5,888,867 bekannt.

Yu B. et al.: "Gate Engineering for Deep-Submicron CMOS Transistors", IEEE Transactions on Electron Devices, U.S., IEEE Inc. New York, Bd. 45, Nr. 6, 1. Juni 1998, Seiten 1253-1261, XP000754177, offenbart die Implantation von Stickstoff in ein Polysilizium-Gate zur Verhinderung einer Bor-Diffusion.

Tsu-Jae King et al.: "A Variable-Work-Function Polycrystalline-Si₁₋ₓGeₓ Gate Material for Submicrometer CMOS Technologies", IEEE Electron Device Letters, U.S., IEEE Inc. New York, Bd. 12, Nr. 10, 1. Oktober 1991, Seiten 533-535, XP000226014, schlägt die Veränderung der Schwellenspannung von SiGe-Filmen vor, indem Germanium-Ionen implantiert werden.

Die U.S.-A-5,426,069 offenbart ein SiGe-Gate eines MOSFETs, welches durch Germanium-Implantation hergestellt wird, um die Schwellenspannung zu verändern.

Die U.S.-A-5,633,177 offenbart die Herstellung von Silizium-Germanium-MOSFETs durch Implantation von Germanium in polykristallines Silizium zum Realisieren von aktiven SiGe-Bereichen.

Ein MOS-Transistor ist ein Feldeffekttransistor mit einer isolierten Steuerelektrode bzw. Gate zur Ansteuerung eines Stromkanals in einem Substrat. Dabei wird die Ladungsträgerdichte in dem Halbleitersubstrat durch die an dem Gateanschluß anliegende Spannung gesteuert. Wenn an die Gate-Elektrode eine genügend hohe Spannung angelegt wird, die eine bestimmte Schwellenspannung überschreitet, wird an der Halbleiteroberfläche zwischen dem Drainanschluß und dem Sourceanschluß des MOSFETs ein Inversionsstromkanal erzeugt, durch den ein Strom fließen kann. Die Gatespannung, die notwendig ist, um den Inversionsstromkanal gerade auszubilden, wird als Schwellenspannung U_{T} des MOSFETs bezeichnet.

Bei der CMOS-Technik werden in dem Halbleitersubstrat gleichzeitig n- und p-Kanal-MOS-Feldeffekttransistoren integriert. Bei einem herkömmlichen CMOS-Herstellungsverfahren wird in ein p-leitende Halbleitersubstrat beispielsweise eine n-Wanne eindiffundiert und anschließend eine selektive Feldoxidation durchgeführt, um die einzelnen Transistorgebiete oberflächlich voneinander zu isolieren. Daraufhin wird eine dünne Oxidschicht gebildet, welche als Streuoxid wirkt. Mittels Ionenimplantation werden dann die Schwellenspannungen der PMOS-Transistoren und der NMOS-Transistoren eingestellt. In einem weiteren Prozeßschritt werden zuerst das Streuoxid entfernt, dann das Gateoxid erzeugt und folgend polykristalline Siliziumschichten für die Gateanschlüsse aufgebracht, und strukturiert sowie nach einer elektrische Isolation des Gatestacks von den Drain- und Sourcegebieten mittels eines Spacers die Diffusion von Akzeptoren für den Drainanschluß und den Sourceanschluß des PMOS-Transistors und eine Diffusion von Donatoren für den Drainanschluß und Sourceanschluß des NMOS durchgeführt. Nach einem Öffnen der Kontaktfenster durch Ätzen der Drain- und Sourcegebiete kann eine Kontaktierung erfolgen.

Die Abstimmung der Schwellenwertspannung U_{T} des PMOS-Transistors und des dazu komplementären NMOS-Transistors der CMOS-Schaltung ist dabei von besonderer Bedeutung, da die Schwellenspannung der beiden komplementären Transistoren gleich sein sollte. Die Schwellenspannung hängt von der Austrittsarbeit an den Gateanschlüssen ab. Als Austrittsarbeit bezeichnet man die Energie, die benötigt wird, um ein Elektron aus einem Kristallverband zu lösen. Die Gate-Elektroden werden herkömmlicherweise aus kristallinem Polysilizium gebildet. Die Austrittsarbeit und somit die Schwellenspannung U_{T} der MOSFET wird dabei durch Dotierung des polykristallinen Siliziums eingestellt. Durch n-Dotierung der Gate-Elektrode des NMOS-Transistors durch p-Dotierung der Gate-Elektrode des PMOS-Transistors können die Schwellenspannungen U_{T} der beiden komplementären MOSFET bei dem herkömmlichen Herstellungsverfahren angeglichen werden. Die Schwellenspannung U_{T} liegt dabei typischerweise zwischen 0,5 Volt und 0,7 Volt.

Die bisherigen Verfahren zur Einstellung der Schwellenspannungen bei NMOS-Transistoren in der CMOS-Herstellungstechnologie haben jedoch den Nachteil, dass aufgrund der unterschiedlichen Dotierung des Gates des NMOS-Transistors und des PMOS-Transistors unterschiedliche Dotierungsstoffe bereitgestellt werden müssen und ferner zusätzliche kostenintensive Verfahrensschritte für die Maskierung und Implantierung der unterschiedlichen Gatedotierungen notwendig sind.

Eine einfachere und kostengünstigere Variante ist es, das Polysilizium für beide Transistorarten bereits, beispielsweise mit der Abscheidung zu dotieren. Der Nachteil ist, dass die Funktionalität des sogenannten buried channel PMOS schlechter ist.

Es ist daher die Aufgabe der vorliegenden Erfindung, ein einfaches Verfahren zur Einstellung der Schwellenspannung bei MOS-Transistoren zu schaffen, bei dem die Schwellenspannung mit einer sehr geringen Anzahl von Prozeßschritten genau einstellbar ist.

Diese Aufgabe wird erfindungsgemäß durch ein Verfahren mit den in Patentanspruch 1 angegebenen Merkmalen gelöst.

Dies bietet den besonderen Vorteil, dass eine aus einer Silizium-Stickstoffverbindung bestehende dünne Schicht zwischen dem Gate und einem darunterliegenden Gateoxid gebildet wird, welche die Bildung einer Germaniumoxidschicht verhindert.

Vorzugsweise wird das mit Germaniumionen implantierte Gate anschließend getempert bzw. wärmebehandelt, indem es für eine vorbestimmte Zeitdauer einer hohen Temperatur ausgesetzt wird.

Dies bietet den besonderen Vorteil, dass eine kristalline Gatestruktur erreicht wird.

Vorzugsweise wird nach dem Implantieren der Stickstoffionen das aus Polysilizium bestehende Gate getempert bzw. wärmebehandelt, indem es für eine bestimmte Zeitdauer einer hohen Temperatur ausgesetzt wird.

Das Verfahren wird vorzugsweise zur Einstellung der Schwellenspannung eines PMOS-Transistors in einer CMOS-Schaltung eingesetzt.

Die Temperatur zur Wärmebehandlung des Gates nach erfolgter Implantierung beträgt vorzugsweise über 1000°C.

Der Anteil von Germanium, das in das aus Polysilizium bestehende Gate implantiert wird, beträgt vorzugsweise etwa-20%.

Im weiteren werden bevorzugte Ausführungsformen des erfindungsgemäßen Verfahrens unter Bezugnahme auf die beigefügten Figuren zur Erläuterung erfindungswesentlicher Merkmale beschrieben.

Fig. 1 zeigt schematisch den Schichtaufbau bei einem MOS-Transistor, dessen Schwellenspannung mit dem erfindungsgemäßen Verfahren eingestellt wird;

Fig. 2 zeigt einen p-Kanal-MOS-Feldeffekttransistor, dessen Schwellenspannung mit dem erfindungsgemäßen Verfahren eingestellt wird;

Fig. 3 zeigt eine CMOS-Struktur, bei dem die Schwellenspannung des PMOS-Transistors mit dem erfindungsgemäßen Verfahren eingestellt wird.

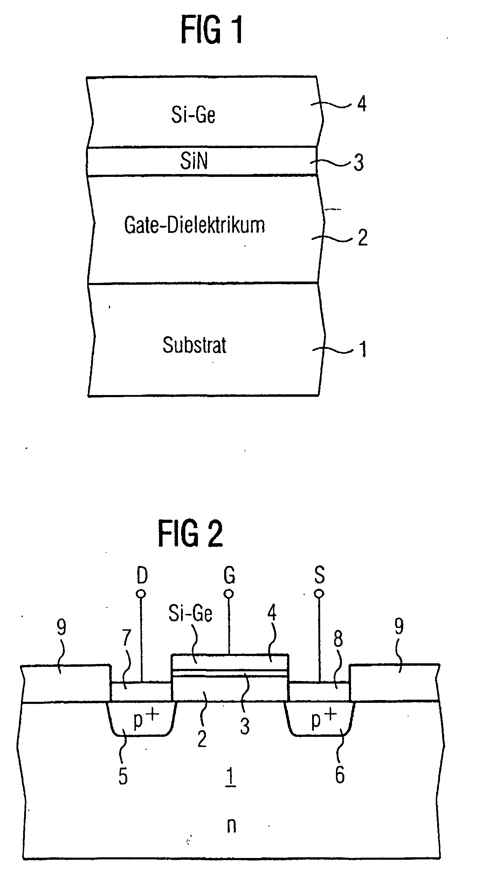

Wie man aus Fig. 2 erkennen kann, wird auf einem Halbleitersubstrat 1 zunächst ein Gate-Dielektrikum 2 durch thermische Oxidation des Substrats 1 oder durch ein Abscheideverfahren aufgebracht. Das Dielektrikum 2 besteht dabei vorzugsweise aus einem Oxid mit einer relativ hohen Dielektrizitätskonstante. Das Gatedielektrikum 2 kann alternativ auch aus Siliziumnitrid hergestellt sein. Auf dem Gate-Dielektrikum 2 wird anschließend polykristallines Silizium zur Ausbildung eine Gate-Steuerelektrode aufgebracht. In dieser Polysiliziumschicht werden Stickstoffionen durch Ionenimplantation implantiert. Anschließend wird das mit Stickstoffionen implantierte Polysilizium getempert, indem es für eine vorbestimmte Zeitdauer einer hohen Temperatur von über 1000°C ausgesetzt wird. Hierdurch entsteht an der Grenzfläche der Polysiliziumschicht zu dem Gate-Dielektrikum 2 eine aus Silizium und Stickstoff bestehende Oxidationssperrschicht 3. In die darüberliegende verbliebene Polysiliziumschicht werden anschließend Germaniumionen- implantiert, um die Austrittsarbeit des aus Polysilizium bestehenden Gates zu verändern. Durch die Implantierung der Germaniumionen entsteht zunächst eine amorphe Siliziumschicht, die durch anschließend Tempern bzw. Annealing bei über 1000°C in einem Ofen zu einer polykristallinen Silizium-Germaniumverbindung gewandelt wird. Die mit Germanium dotierte Polysiliziumschicht 4 bildet den Gate-Anschluß des MOS-Transistors, wobei durch den prozentualen Anteil von Germanium in dem Polysilizium die Schwellenspannung U_{T}, bei der sich eine Inversionsschicht in dem Substrat 1 bildet, eingestellt wird.

Fig. 2 zeigt einen PMOS-Transistor, dessen Schwellenspannung U_{T} sich durch Implantierung von Germaniumionen in dem Gate eingestellt ist. Der PMOS-Transistor weist ein n-dotiertes Halbleitersubstrat 1 auf, mit einem p⁺-dotierten Drainbereich 5 und einem p⁺-dotierten Sourcebereich 6. Der Drainbereich 5 sowie der Sourcebereich 6 sind jeweils aus über Polysilizium bestehende Anschlüsse 7, 8 elektrisch kontaktiert. Das Halbleitersubstrat 1 ist im übrigen mit Feldoxid 9 bedeckt.

Das erfindungsgemäße Verfahren zur Einstellung der Schwellenspannung eines MOS-Transistors eignet sich insbesondere zur Einstellung der Schwellenspannung U_{T} von MOS-Transistoren in einem CMOS-Herstellungsverfahren.

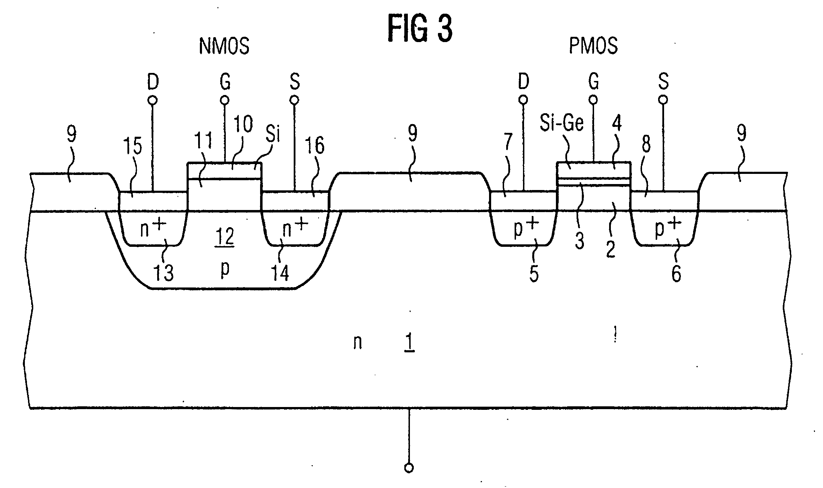

Fig. 3 zeigt eine CMOS-Schaltung mit einem PMOS-Transistor und einem dazu komplementären NMOS-Transistor. Der NMOS-Transistor weist ein aus Polysilizium bestehendes Gate 10 auf, das durch ein Dielektrikum 11 von einem p-dotierten Wannenbereich 12 getrennt liegt. Die p-dotierte Wanne 12 befindet sich in dem n-dotierten Halbleitersubstrat 1. Der NMOS-Transistor weist einen n⁺-dotierten Drainbereich 13 und einen n⁺-dotierten Sourcebereich 14 auf. Der Drainbereich 13 und der Sourcebereich 14 sind jeweils über Polysiliziumanschlüsse 15, 16 elektrisch kontaktierbar.

Durch lokale Germaniumionenimplantation in dem Gate 3 des PMOS-Transistors der in Fig. 3 dargestellten CMOS-Schaltung kann die Schwellenspannung U_{TP} des PMOS-Transistors an die Schwellenspannung U_{TN} des NMOS-Transistors angeglichen werden. Je höher die Konzentration des implantierten Germaniums ist, desto stärker wird die Schwellenspannung U_{TP} zur Ausbildung des Inversionsstromkanals bei dem PMOS-Transistor abgesenkt. Die Schwellenspannung U_{TN} des NMOS-Transistors wird wie bei den herkömmlichen Herstellungsverfahren durch n⁺-Dotierung des aus Polysilizium bestehenden Gates 10 erreicht. Die Implantierung von Germaniumionen in die Polysiliziumschicht erfolgt lediglich im Bereich des PMOS-Transistors und nicht in dem Bereich des NMOS-Transistors. Dies wird mittels einer Lack- oder Hartmaske erreicht, die die Polysiliziumschicht zur Ausbildung der Gateanschlüsse im Bereich des NMOS-Transistors bei der Germaniumionenimplantation lokal bedeckt. Die Maskierung verhindert dabei ein Eindringen von Germaniumionen in den aus Polysilizium bestehenden Gatebereich 10 des späteren NMOS-Transistors. Eine p⁺-Dotierung des Gateanschlusses bei dem PMOS-Transistor zur Anpassung der Schwellenspannung U_{TP} an die Schwellenspannung U_{TN} des NMOS-Transistors braucht nicht zu erfolgen, da die Schwellenspannung U_{TP} des PMOS-Transistors durch die Implantation von Germaniumionen erfolgt. Hierdurch wird die Herstellung der CMOS-Schaltung insgesamt vereinfacht.

Eine hohe Konzentration von Germaniumionen in dem SiGe-Gate 4 an der Grenzfläche zu dem darunterliegenden Dielektrikum 2 führt zu einer starken Beeinflussung der Austrittsarbeit und somit zu einer starken Veränderung der Schwellenspannung. Durch die Ionenimplantation lässt sich die Dotierungskonzentration der Germaniumionen und somit die Schwellenspannung U_{T} sehr genau einstellen. Durch Variation von Energie und Einfallsrichtung der implantierten Germaniumionen lassen sich zudem Konzentrationsprofile nach Form und Lage weitestgehend steuern. Die Prozeßtemperaturen können dabei so niedrig gehalten werden, dass eine Eindiffusion von schädlichen Verunreinigungen ausgeschlossen wird. Die durch die Ionenimplantation in dem Halbleiterkristall hervorgerufenen Strukturveränderungen lassen sich durch anschließendes Ausheilen durch Wärmebehandlung kompensieren.

Gemäß dem erfindungsgemäßen Verfahren werden die Kurzkanaleigenschaften des PMOS-Transistors verbessert, ohne dass das Herstellungsverfahren für den NMOS-Transistor geändert werden muß. Dabei wird das aus Polysilizium bestehende Gate 10 des NMOS-Transistors und das aus Germaniumionen implantierte Siliziumgate 4 des PMOS-Transistors in einem Abscheide- und Ätzprozeß hergestellt, wodurch der Herstellungsprozeß einer CMOS-Struktur erheblich vereinfacht wird.

Eine Zweistufen-Polysiliziumabscheidung mit Germaniumimplantierung mit anschließendem Ausheilen kann nach jeder Abscheidung durchgeführt werden. Die Implantierung mit Germaniumionen nach der zweiten Abscheidung zerstört dabei gleichzeitig das Siliziumoxid, das sich zwischen den Abscheideprozessen gebildet hat. Durch eine Zweistufen-Polysiliziumabscheidung mit Germaniumionenimplantierung und anschließender Ausheilung führt zu einer Verbesserung von Germanium-Depletionseffekten an der Gate-Gateoxid-Grenzfläche.

Durch die Implantierung von Stickstoffionen zur Ausbildung einer Oxidationssperrschicht wird die Ausbildung einer Germaniumoxidschicht an der Gateoxidoberfläche verhindert. Dies kann auch durch die Implantierung von Halogen-Ionen erreicht werden.

## Patentansprüche

1. Verfahren zur Einstellung der Schwellenspannung eines MOS-Transistors, der ein aus Polysilizium bestehendes Gate aufweist, bei dem Germaniumionen in das aus Polysilizium bestehende Gate (4) zur Änderung der Austrittsarbeit des Gates implantiert werden, **dadurch gekennzeichnet, daß** vor der Implantation der Germaniumionen Stickstoffionen in das aus Polysilizium bestehende Gate (4) zur Ausbildung einer Oxidationssperrschicht implantiert werden.

2. Verfahren zur Einstellung der Schwellenspannung eines MOS-Transistors, bei dem das mit Germaniumionen implantierte Gate (4) anschließend durch Wärmebehandlung ausgeheilt wird, indem es für eine vorbestimmte Zeitdauer einer hohen Temperatur ausgesetzt wird.

3. Verfahren nach Anspruch 1 oder 2,
**dadurch gekennzeichnet,**
**dass** nach der Implantation der Stickstoffionen das aus Polysilizium bestehende Gate zur Ausheilung wärmebehandelt wird, indem es für eine bestimmte Zeitdauer einer hohen Temperatur ausgesetzt wird.

4. Verfahren nach einem der vorangehenden Ansprüche,
**dadurch gekennzeichnet,**
**dass** die Schwellenspannung eines PMOS-Transistors oder eines NMOS-Transistors in einer CMOS-Schaltung eingestellt wird.

5. Verfahren nach einem der vorangehenden Ansprüche,
**dadurch gekennzeichnet,**
**dass** die Temperatur bei der Wärmebehandlung über 1000°C liegt.

6. Verfahren nach einem der vorangehenden Ansprüche,
**dadurch gekennzeichnet,**
**dass** der Germaniumanteil des Gates (4) nach der Implantation der Germaniumionen etwa 20% beträgt.

## Claims

1. Method for setting the threshold voltage of a MOS transistor having a gate composed of polysilicon, in which germanium ions are implanted into the gate (4) composed of polysilicon in order to change the work function of the gate,
**characterized**
**in that**, prior to the implantation of the germanium ions, nitrogen ions are implanted into the gate (4) composed of polysilicon in order to form an oxidation barrier layer.

2. Method for setting the threshold voltage of a MOS transistor, in which the gate (4) implanted with germanium ions is subsequently annealed by thermal treatment by being exposed to a high temperature for a predetermined period of time.

3. Method according to Claim 1 or 2,
**characterized**
**in that**, after the implantation of the nitrogen ions, the gate composed of polysilicon is subjected to thermal treatment for annealing purposes by being exposed to a high temperature for a specific period of time.

4. Method according to one of the preceding claims,
**characterized**
**in that** the threshold voltage of a PMOS transistor or of an NMOS transistor in a CMOS circuit is set.

5. Method according to one of the preceding claims,
**characterized**
**in that** the temperature during the thermal treatment lies above 1000°C.

6. Method according to one of the preceding claims,
**characterized**
**in that** the germanium proportion of the gate (4) after the implantation of the germanium ions is about 20%.

## Revendications

1. Procédé pour ajuster la tension de seuil d'un transistor MOS comportant une porte en polysilicium où des ions de germanium sont implantés dans la porte (4) se composant de polysilicium, en vue de la modification du travail de sortie de la porte, **caractérisé en ce que** des ions d'azote sont implantés dans la porte (4) composée de polysilicium, avant l'implantation des ions de germanium, en vue de la formation d'une couche d'arrêt d'oxydation.

2. Procédé pour ajuster la tension de seuil d'un transistor MOS où la porte (4) implantée d'ions de germanium est régénérée subséquemment par un traitement thermique, dans lequel celle-ci est soumise à une haute température pendant une période prédéfinie.

3. Procédé selon la revendication 1 ou 2, **caractérisé en ce qu**'à la suite de l'implantation des ions d'azote, la porte composée de polysilicium est soumise à un traitement thermique en vue de sa régénération, en ce qu'elle est soumise à une haute température pendant une période prédéfinie.

4. Procédé selon l'une des revendications précédentes, **caractérisé en ce que** la tension de seuil d'un transistor PMOS ou d'un transistor NMOS est ajustée dans un circuit CMOS.

5. Procédé selon l'une des revendications précédentes, **caractérisé en ce que** la température lors du traitement thermique est supérieure à 1000 °C.

6. Procédé selon l'une des revendications précédentes, **caractérisé en ce que** le pourcentage de germanium dans la porte (4) suite à l'implantation des ions de germanium est de 20 % environ.
